# EUROPEAN PATENT APPLICATION

(11) **EP 4 756 810 A1**
(43) Date of publication of application: **10.06.2026**
(21) Application number: 25190907.3
(22) Date of filing: 22.07.2025
(51) Int. Cl.: G11C 16/10, G11C 7/10, G11C 7/24, G11C 16/04

(54) **STORAGE DEVICE AND OPERATING METHOD OF STORAGE DEVICE**

(30) Priority: 06.12.2024 KR 20240180923; 17.06.2025 US 202519240734
(71) Applicant: Samsung Electronics Co., Ltd., Suwon-si, Gyeonggi-do 16677 (KR)
(72) Inventor: LEE, Kyungduk, 16677 Suwon-si, Gyeonggi-do (KR); SHIN, Seo-Hyun, 16677 Suwon-si, Gyeonggi-do (KR); LEE, Jinwook, 16677 Suwon-si, Gyeonggi-do (KR)
(74) Representative: Kuhnen & Wacker Patent- und Rechtsanwaltsbüro PartG mbB

(57) **Abstract**

A storage device including a nonvolatile memory device including a plurality of memory blocks, each memory block of the plurality of memory blocks including a plurality of sub-blocks; and a storage controller configured to send a command and address to the nonvolatile memory device, communicate first data with the nonvolatile memory device, allocate one of the plurality of sub-blocks to a first region based on first information about program speeds or erase speeds of the plurality of sub-blocks, and write second data of a write request received together with second information from an external host device in the first region.

## Description

### BACKGROUND

Some example embodiments of the present inventive concepts described herein relate to a storage device, and more particularly, relate to a storage device performing a purge operation at an improved speed and/or an operating method of the storage device.

A storage device refers to a device, which stores data under control of a host device, such as a computer, a smartphone, and/or a smart pad. The storage device includes a device, which stores data on a magnetic disk, such as a hard disk drive (HDD), and/or a device, which stores data in a semiconductor memory, in particular, a nonvolatile memory, such as a solid state drive (SSD) and/or a memory card.

The nonvolatile memory includes a read only memory (ROM), a programmable ROM (PROM), an electrically programmable ROM (EPROM), an electrically erasable and programmable ROM (EEPROM), a flash memory, a phase-change RAM (PRAM), a magnetic RAM (MRAM), a resistive RAM (RRAM), a ferroelectric RAM (FRAM), etc.

The operating speed of the host device, which communicates with the storage device, such as a computer, a smartphone, and/or a smart pad is improved as semiconductor manufacturing technologies develop. Also, the size of content used in the storage device and the host device of the storage device is increasing. For this reason, it may be advantageous to provide a storage device with an improved operating speed.

### SUMMARY

Some example embodiments of the present inventive concepts provide a storage device performing a purge operation at an improved speed and/or an operating method of the storage device.

According to some example embodiments, a storage device includes a nonvolatile memory device including a plurality of memory blocks, each memory block of the plurality of memory blocks including a plurality of sub-blocks; and a storage controller configured to send a command and address to the nonvolatile memory device, communicate first data with the nonvolatile memory device, allocate one of the plurality of sub-blocks to a first region based on first information about program speeds or erase speeds of the plurality of sub-blocks, and write second data of a write request received together with second information from an external host device in the first region.

According to some example embodiments, a storage device includes a nonvolatile memory device including a plurality of memory blocks; and a storage controller configured to send a command and address to the nonvolatile memory device, communicate first data with the nonvolatile memory device, write second data of a first write request received together with first information from an external host device in the first region, read second information about memory cells allocated to the first region from the nonvolatile memory device, and write third data of a second write request received together with third information from the external host device in the first region based on the second information.

According to some example embodiments, an operating method of a storage device, the storage device including a nonvolatile memory device and a storage controller, the nonvolatile memory device including a plurality of memory blocks, each of the plurality of memory blocks including a plurality of sub-blocks, and the storage controller configured to send a command and address to the nonvolatile memory device and communicate first data with the nonvolatile memory device, the method including allocating, at the storage controller, one of the plurality of sub-blocks to a first region, based on first information about program speeds or erase speeds of the plurality of sub-blocks, and writing, at the storage controller, second data of a write request received together with second information from an external host device in the first region.

According to some example embodiments, a system may comprise a host, and a storage device, the storage device including a nonvolatile memory device, the nonvolatile memory device including a plurality of memory blocks, each memory block of the plurality of memory blocks including a plurality of sub-blocks, and a storage controller, the storage controller configured to send a command and address to the nonvolatile memory device, communicate first data with the nonvolatile memory device, allocate one of the plurality of sub-blocks to a first region based on first information about program speeds or erase speeds of the plurality of sub-blocks, receive a write request together with second information from the host, and write second data of the write request in the first region.

In some example embodiments, the storage controller is configured to allocate first sub-blocks of the plurality of sub-blocks to the first region, the first sub-blocks being fast in the program speeds or the erase speeds.

In some example embodiments, the second information includes a specific logical unit or a specific stream identifier.

In some example embodiments, the nonvolatile memory device includes a substrate and a plurality of cell strings arranged on the substrate along a first direction and a second direction, each cell string of the plurality of cell strings including a plurality of stacks stacked on the substrate along a third direction, and each stack of the plurality of stacks including a plurality of memory cells stacked along the third direction.

### BRIEF DESCRIPTION OF THE FIGURES

The above and other objects and features of the present inventive concepts will become apparent by describing in detail some example embodiments thereof with reference to the accompanying drawings.
FIG. 1 illustrates a computing device according to some example embodiments.
FIG. 2 is a block diagram illustrating a nonvolatile memory device according to some example embodiments.
FIG. 3 is a circuit diagram illustrating an example of one memory block among memory blocks of FIG. 2 according to some example embodiments.
FIG. 4 illustrates a side view of an a-th memory block according to some example embodiments.
FIG. 5 illustrates an operating method of a storage device according to some example embodiments.
FIG. 6 illustrates an example in which a first region is allocated in an a-th memory block according to some example embodiments.
FIG. 7 illustrates another example in which a first region is allocated in an a-th memory block according to some example embodiments.
FIG. 8 illustrates an example in which a storage device performs a purge operation depending on a request of a host according to some example embodiments.
FIG. 9 illustrates an example in which an erase operation is performed in a nonvolatile memory device according to some example embodiments.
FIG. 10 illustrates an example in which a security erase operation is performed in a nonvolatile memory device according to some example embodiments.
FIG. 11 illustrates an example in which a first region is allocated in a plurality of memory blocks according to some example embodiments.
FIG. 12 illustrates an example in which an RPMB is allocated to first sub-blocks of a third memory block according to some example embodiments.
FIG. 13 illustrates an example in which some of first sub-blocks of a first memory block and some of first sub-blocks of a second memory block are together allocated to an RPMB according to some example embodiments.
FIG. 14 illustrates an example in which a storage controller allocates third sub-blocks of a first memory block to an RPMB according to some example embodiments.
FIG. 15 illustrates an operating method of a storage device according to some example embodiments.
FIG. 16 illustrates an example in which priorities are assigned by a storage controller according to some example embodiments.
FIG. 17 is a diagram illustrating a system according to some example embodiments.

### DETAILED DESCRIPTION

Below, some example embodiments of the present inventive concepts will be described in detail and clearly to such an extent that an ordinary one in the art easily carries out the present inventive concepts.

It will be understood that when an element such as a layer, film , region, or substrate is referred to as being "on" another element, it may be directly on the other element or intervening elements may also be present. In contrast, when an element is referred to as being "directly on" another element, there are no intervening elements present. It will further be understood that when an element is referred to as being "on" another element, it may be above or beneath or adjacent (e.g., horizontally adjacent) to the other element.

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

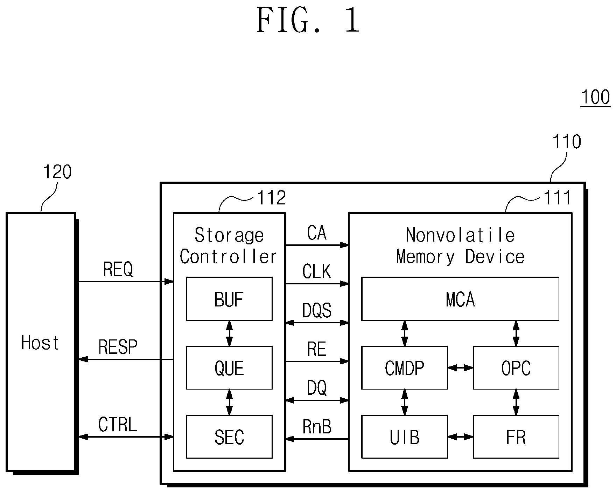

FIG. 1 illustrates a computing device 100 according to some example embodiments. Referring to FIG. 1, the computing device 100 may include a storage device 110 and a host (or a host device) 120.

The storage device 110 may operate under control of the host 120. The storage device 110 may include a nonvolatile memory device 111 and a storage controller 112.

The storage controller 112 may transmit a command and address CA to the nonvolatile memory device 111. For example, the storage controller 112 may transmit a clock signal CLK to the nonvolatile memory device 111 and may transmit the command and address CA to the nonvolatile memory device 111 in synchronization with the clock signal CLK.

The storage controller 112 may communicate a data strobe signal DQS with the nonvolatile memory device 111 and may transmit and/or send a read enable signal RE to the nonvolatile memory device 111. The storage controller 112 may communicate data DQ with the nonvolatile memory device 111 in synchronization with the data strobe signal DQS.

In some example embodiments, when the storage controller 112 transmits and/or sends the data DQ to the nonvolatile memory device 111, the storage controller 112 may transmit and/or send the data strobe signal DQS to the nonvolatile memory device 111 and may transmit and/or send the data DQ to the nonvolatile memory device 111 in synchronization with the data strobe signal DQS.

In some example embodiments, when the storage controller 112 receives the data DQ from the nonvolatile memory device 111, the storage controller 112 may transmit and/or send the read enable signal RE to the nonvolatile memory device 111. The nonvolatile memory device 111 may delay the read enable signal RE to generate the data strobe signal DQS. The nonvolatile memory device 111 may transmit and/or send the data strobe signal DQS to the storage controller 112 and may transmit and/or send the data DQ to the storage controller 112 in synchronization with the data strobe signal DQS.

The nonvolatile memory device 111 may transmit and/or send a ready/busy signal RnB to the storage controller 112. In some example embodiments, when the ready/busy signal RnB is at a first level (e.g., a high level), the ready/busy signal RnB may indicate that the nonvolatile memory device 111 is in a state where it is possible to receive a new command, or alternatively an additional command, and to perform a new access operation, or alternatively an additional access operation, to data written in the nonvolatile memory device 111. In some example embodiments, when the ready/busy signal RnB is at a second level (e.g., a row level), the ready/busy signal RnB may indicate that the nonvolatile memory device 111 is in a state where it is impossible to receive a new command, or alternatively an additional command, and to perform a new access operation, or alternatively an access operation, to data written in the nonvolatile memory device 111.

The nonvolatile memory device 111 may include a memory cell array MCA, a command parser CMDP, an operation controller OPC, a universal internal buffer UIB, and a feature register FR.

The memory cell array MCA may include a plurality of memory cells. The nonvolatile memory device 111 may store data in the memory cells of the memory cell array MCA. The data stored in the memory cells of the memory cell array MCA may be retained even though the power of the storage device 110 is turned off.

The command parser CMDP may parse a command received as the command and address CA from the storage controller 112. The command parser CMDP may transfer a result of the parsing to the operation controller OPC. The operation controller OPC may control an operation of the nonvolatile memory device 111, based on the parsing result of the command parser CMDP. For example, the operation controller OPC may control the nonvolatile memory device 111 to perform a read operation, a write operation, and/or an erase operation.

The universal internal buffer UIB may store settings associated with various operations of the nonvolatile memory device 111. For example, the universal internal buffer UIB may store various parameters associated with the read operation, the write operation, and/or the erase operation, such as voltage levels and/or voltage application times. In some example embodiments, the universal internal buffer UIB may be implemented with an electrical fuse. As the storage controller 112 transmits and/or sends a specific, or alternatively desired, command through first lines through which the command and address CA is transferred, the storage controller 112 may enter a mode of setting the universal internal buffer UIB and may set values of the universal internal buffer UIB through second lines through which the data DQ are transferred. Afterwards, as the storage controller 112 transmits and/or sends the specific, or alternatively desired, command or another (e.g., additional) specific, or alternatively desired, command through the first lines through which the command and address CA is transferred, the storage controller 112 may terminate the mode of setting the universal internal buffer UIB.

The feature register FR may store various features associated with a command received through the first lines through which the command and address CA is transferred. For example, the feature register FR may store information about whether to execute each command in any manner. The storage controller 112 may set the feature register FR by transmitting and/or sending a set feature command through the first lines through which the command and address CA is transferred.

The storage controller 112 may receive a request REQ from the host 120. In response to the request REQ, the storage controller 112 may transmit and/or send the command and address CA to the nonvolatile memory device 111 to perform a specific, or alternatively desired, operation and/or may perform an internal operation. In some example embodiments, when the operation according to the request REQ is completed, the storage controller 112 may transmit and/or send a response RESP to the host 120. The response RESP may include information about the request REQ and information about an execution result of the operation according to the request REQ. The storage controller 112 may communicate various control signals CTRL for management of the storage device 110 with the host 120.

The storage controller 112 may include a buffer memory BUF, a queue QUE, and a security erase controller SEC. The storage controller 112 may buffer data to be written from the host 120 to the nonvolatile memory device 111 and data to be read from the nonvolatile memory device 111 to the host 120 by using the buffer memory BUF.

The storage controller 112 may read a map table or a portion of the map table from the nonvolatile memory device 111 so as to be stored in the buffer memory BUF. The map table may include information about a relationship between logical addresses managed by the host 120 and physical addresses of the nonvolatile memory device 111. The storage controller 112 may generate the map table when data are written in the nonvolatile memory device 111 by the host 120. The storage controller 112 may process a read request of the host 120 by using the generated map table.

The storage controller 112 may queue requests transferred from the host 120 in the queue QUE. The storage controller 112 may perform ordering of changing an execution order of requests enqueued into the queue QUE.

The security erase controller SEC of the storage controller 112 may control a security erase operation. For example, when a purge request is received from the host 120, the security erase controller SEC of the storage controller 112 may perform the security erase operation.

For example, the nonvolatile memory device 111 may include a NAND flash memory device. The nonvolatile memory device 111 may not support an overwrite operation. In some example embodiments, when the host 120 requests the update of data written in the storage device 110, the storage controller 112 may invalidate original data by marking the original data present in the nonvolatile memory device 111 in the map table as "invalid" and may write update data in a free region. Through the invalidation of data, the storage controller 112 may decrease the number of times of occurrence of the read operation, the write operation, and/or the erase operation in the nonvolatile memory device 111 and may improve the lifetime of the nonvolatile memory device 111.

According to some example embodiments, a portion of data which the host 120 stores in the storage device 110 may be security data, and it may be advantageous to provide the security data with high security. For example, the host 120 may store a key for data encryption in the storage device 110. In some example embodiments, even though the security data are invalidated in the map table of the storage device 110, the security data may be exposed by means such as hacking. Accordingly, the host 120 may request physical erase of the security data from the storage device 110 rather than the invalidation of the security data. For example, the host 120 may request physical erase of data associated with the purge request by transmitting and/or sending the purge request to the storage device 110.

In response to the purge request of the host 120, the storage controller 112 may physically erase data of the nonvolatile memory device 111, which are associated with the purge request. For example, the security erase controller SEC of the storage controller 112 may control the purge operation in response to the purge request. The security erase controller SEC may control the nonvolatile memory device 111 such that the data identified by the purge request are physically erased. In some example embodiments, when copy data of the security data, for example, invalidated copy data of the security data exists, the storage controller 112 may also physically erase the invalidated copy data.

In some example embodiments, the host 120 may activate and/or deactivate the purge operation according to the purge request. In some example embodiments, the host 120 may activate and/or deactivate the purge operation through a universal flash storage (UFS) query request UFS protocol information unit (UPIU).

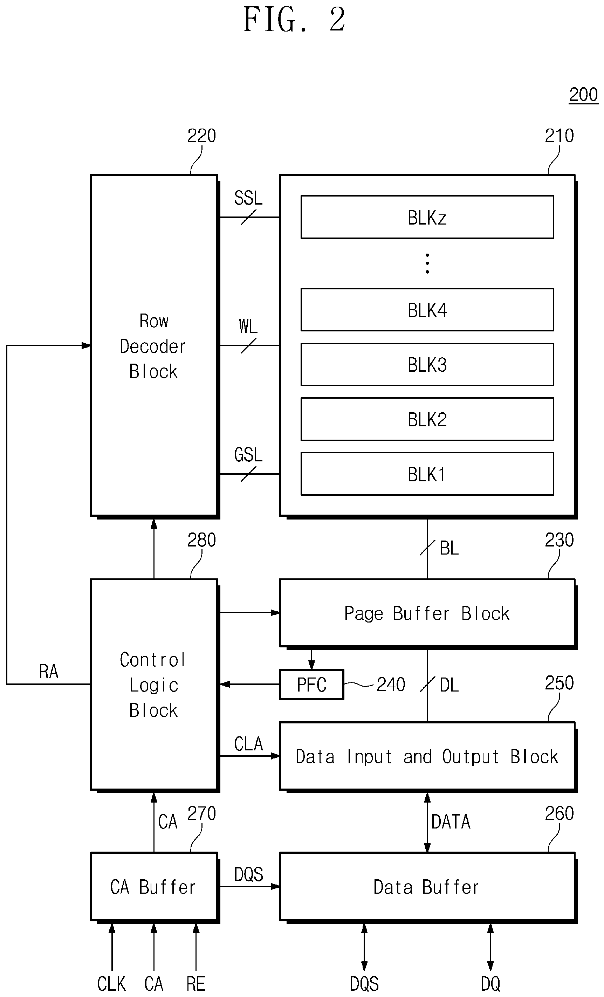

FIG. 2 is a block diagram illustrating a nonvolatile memory device 200 according to some example embodiments. Referring to FIGS. 1 and 2, the nonvolatile memory device 200 includes a memory cell array 210, a row decoder block 220, a page buffer block 230, a pass/fail check block (PFC) 240, a data input and output block 250, a data buffer 260, a command and address buffer 270, and a control logic block 280.

The memory cell array 210 includes a plurality of memory blocks BLK1 to BLKz. Each of the memory blocks BLK1 to BLKz includes a plurality of memory cells. Each of the memory blocks BLK1 to BLKz may be connected to the row decoder block 220 through at least one ground selection line GSL, word lines WL, and at least one string selection line SSL. Some of the word lines WL may be used as dummy word lines. Each of the memory blocks BLK1 to BLKz may be connected to the page buffer block 230 through a plurality of bit lines BL. The plurality of memory blocks BLK1 to BLKz may be connected in common to the plurality of bit lines BL.

In some example embodiments, each of the plurality of memory blocks BLK1 to BLKz may correspond to a unit of the erase operation. Memory cells belonging to each memory block may be erased at the same time. In some example embodiments, each memory block may be divided into a plurality of sub-blocks. Each of the plurality of sub-blocks may correspond to a unit of the erase operation. For example, the unit of the erase operation may be the smallest number of sub-blocks that may be erased at one time.

The row decoder block 220 is connected to the memory cell array 210 through the ground selection lines GSL, the word lines WL, and the string selection lines SSL. The row decoder block 220 operates under control of the control logic block 280.

The row decoder block 220 may decode a row address RA received from the control logic block 280 and may control voltages to be applied to the string selection lines SSL, the word lines WL, and the ground selection lines GSL based on the decoded row address.

The page buffer block 230 is connected to the memory cell array 210 through the plurality of bit lines BL. The page buffer block 230 is connected to the data input and output block 250 through a plurality of data lines DL. The page buffer block 230 operates under control of the control logic block 280.

In a program operation, the page buffer block 230 may store data to be written in memory cells. The page buffer block 230 may apply voltages to the plurality of bit lines BL based on the stored data. In a read operation or in a verify read operation that is performed in the program operation or in the erase operation, the page buffer block 230 may sense voltages of the bit lines BL and may store a sensing result.

In the verify read operation associated with the program operation or the erase operation, the pass/fail check block 240 may verify the sensing result of the page buffer block 230. For example, in the verify read operation, which is performed in the program operation, the pass/fail check block 240 may count the number of values (e.g., the number of "0"s) corresponding to on-cells which are not programmed to a target threshold voltage or higher.

In the verify read operation, which is performed in the erase operation, the pass/fail check block 240 may count the number of values (e.g., the number of "1"s) corresponding to off-cells which are not erased to a target threshold voltage or lower. In some example embodiments, when a counting result is greater than or equal to a threshold value, the pass/fail check block 240 may output a fail signal to the control logic block 280. In some example embodiments, when the counting result is smaller than the threshold value, the pass/fail check block 240 may output a pass signal to the control logic block 280. Depending on the verification result of the pass/fail check block 240, a program loop of the program operation may be further performed, and/or an erase loop of the erase operation may be further performed.

The data input and output block 250 is connected to the page buffer block 230 through the plurality of data lines DL. The data input and output block 250 may receive a column address CLA from the control logic block 280. The data input and output block 250 may output data read by the page buffer block 230 to the data buffer 260 depending on the column address CLA. The data input and output block 250 may transfer data received from the data buffer 260 to the page buffer block 230, based on the column address CLA.

The data buffer 260 may operate under control of the control logic block 280. The data buffer 260 may receive the data DQ from the storage controller 112 in synchronization with the data strobe signal DQS from the storage controller 112. The data buffer 260 may receive the data strobe signal DQS from the command and address buffer 270. The data buffer 260 may output the data DQ to the storage controller 112 in synchronization with the data strobe signal DQS received from the command and address buffer 270.

The command and address buffer 270 may operate under control of the control logic block 280. The command and address buffer 270 may receive the command and address CA in synchronization with the clock signal CLK from the storage controller 112. The command and address buffer 270 may transfer the received command and address CA to the control logic block 280. The command and address buffer 270 may receive the read enable signal RE from the storage controller 112. The command and address buffer 270 may delay the read enable signal RE to generate the data strobe signal DQS. The command and address buffer 270 may transfer the generated data strobe signal DQS to the data buffer 260.

The control logic block 280 may receive the command and address CA from the command and address buffer 270. The control logic block 280 may parse a command of the command and address CA received from the command and address buffer 270 and may control the nonvolatile memory device 200 depending on the parsed command. The control logic block 280 may extract the row address RA and the column address CLA by decoding an address of the command and address CA received from the command and address buffer 270. The control logic block 280 may transfer the row address RA to the row decoder block 220 and may transfer the column address CLA to the data input and output block 250.

In some example embodiments, the control logic block 280 may include the command parser CMDP, the operation controller OPC, the universal internal buffer UIB, and the feature register FR described with reference to FIG. 1.

In some example embodiments, the nonvolatile memory device 200 may be manufactured in a bonding method. The memory cell array 210 may be manufactured by using a first wafer, and the row decoder block 220, the page buffer block 230, the pass/fail check block 240, the data input and output block 250, the data buffer 260, the command and address buffer 270, and the control logic block 280 may be manufactured by using a second wafer. The nonvolatile memory device 200 may be implemented by coupling the first wafer and the second wafer such that an upper surface of the first wafer and an upper surface of the second wafer face each other.

According to some example embodiments, the nonvolatile memory device 200 may be manufactured in a cell over peri (COP) method. A peripheral circuit including the row decoder block 220, the page buffer block 230, the pass/fail check block 240, the data input and output block 250, the data buffer 260, the command and address buffer 270, and the control logic block 280 may be implemented on a substrate. The memory cell array 210 may be implemented over the peripheral circuit. The peripheral circuit and the memory cell array 210 may be connected by using the through vias.

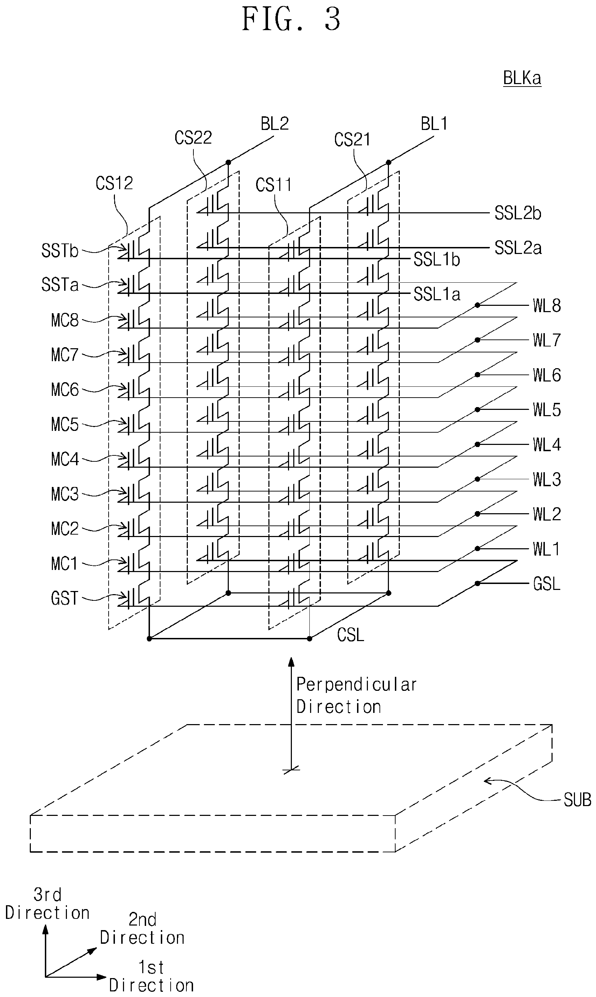

FIG. 3 is a circuit diagram illustrating an example of one memory block BLKa of the memory blocks BLK1 to BLKz of FIG. 2 according to some example embodiments. Referring to FIG. 3, a plurality of cell strings CS11, CS12, CS21, and CS22 may be disposed on a substrate SUB in rows and columns. Each row may extend along a first direction. Each column may extend along a second direction. The plurality of cell strings CS11, CS12, CS21, and CS22 may be connected in common to a common source line CSL formed on (or in) the substrate SUB. In FIG. 3, a location of the substrate SUB is depicted as an example for better understanding of the structure of the memory block BLKa according to some example embodiments.

Cell strings CS11, CS12, CS21, and CS22 of each row may be connected in common to the ground selection line GSL and may be connected to corresponding string selection lines among first string selection lines SSL1a and SSL1b and second string selection lines SSL2a and SSL2b. The strings of each column may be connected to a corresponding bit line among a first bit line BL1 and a second bit line BL2.

Each cell string CS11, CS12, CS21, and CS22 may include at least one ground selection transistor GST connected to the ground selection line GSL and a plurality of memory cells MC1 to MC8 respectively connected to a plurality of word lines WL1 to WL8. Cell strings CS11 and CS12 of the first row may further include string selection transistors SSTa and SSTb respectively connected to the first string selection lines SSL1a and SSL1b. Cell strings CS22 and CS21 of the second row may further include string selection transistors SSTa and SSTb respectively connected to the second string selection lines SSL2a and SSL2b.

In each cell string CS11, CS12, CS21, CS22, the ground selection transistor GST, the memory cells MC1 to MC8, and the string selection transistors SSTa and SSTb may be connected in series in a direction perpendicular to the substrate SUB, for example, a third direction and may be sequentially stacked in the direction perpendicular to the substrate SUB. In each of the cell strings CS11, CS12, CS21, and CS22, at least one of the memory cells MC1 to MC8 may be used as a dummy memory cell. The dummy memory cell may not be programmed (e.g., may be program-inhibited) or may be programmed to be different from that of the remaining memory cells among the memory cells MC1 to MC8.

In some example embodiments, memory cells that are located at the same height and are associated with one string selection line SSL1a, SSL1b, SSL2a, or SSL2b may constitute one physical page. Memory cells of one physical page may be connected to one sub-word line. Sub-word lines of physical pages located at the same height may be connected in common to one word line. Below, the term "word line" may be used to indicate a word line or a sub-word line and may be interpreted based on the context.

An example according to some example embodiments in which the memory block BLKa includes the cell strings CS11, CS12, CS21, and CS22 at intersections of the first row corresponding to the first string selection lines SSL1a and SSL1b, the second row corresponding to the second string selection lines SSL2a and SSL2b, the first column corresponding to the first bit line BL1, and the second column corresponding to the second bit line BL2 is illustrated, but the numbers of rows and columns of cell strings included in the memory block BLKa are not limited thereto.

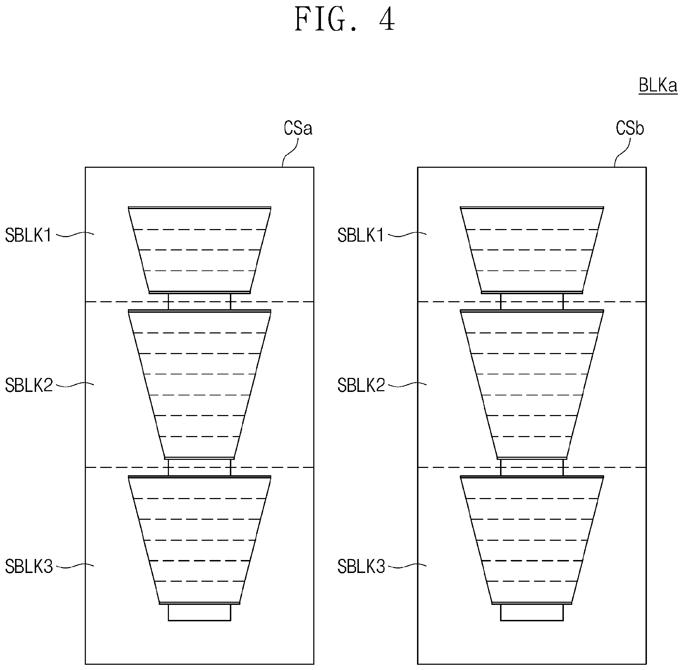

FIG. 4 illustrates a side view of the a-th memory block BLKa according to some example embodiments. Referring to FIGS. 1, 2, 3, and 4, each of the a-th cell string CSa and the b-th cell string CSb may include a plurality of stacks stacked on a substrate. Each stack may indicate a portion of a cell string, in which a width increases as a distance from the substrate increases. For example, each of the a-th cell string CSa and the b-th cell string CSb may include three stacks.

The storage controller 112 may allocate the stacks of each of the a-th cell string CSa and the b-th cell string CSb to sub-blocks. For example, the storage controller 112 may allocate the stacks of each of the a-th cell string CSa and the b-th cell string CSb to a first sub-block SBLK1, a second sub-block SBLK2, and a third sub-block SBLK3. The sub-block may correspond to a unit of the erase operation. The storage controller 112 may generate an erase (ERS) command for each sub-block SBLK1, SBLK2, SBLK3.

In some example embodiments, capacities of the stacks included in each of the a-th cell string CSa and the b-th cell string CSb may be different. As illustrated in FIG. 4, in each stack, a dotted line may be a division line of memory cells. For example, the stack of the first sub-block SBLK1 may include four layers of memory cells. The second sub-block SBLK2 may include seven layers of memory cells. The third sub-block SBLK3 may include six layers of memory cells. However, the number of memory cells included in each stack according to some example embodiments is not limited thereto. Memory cells belonging to each layer may be connected to the same word line.

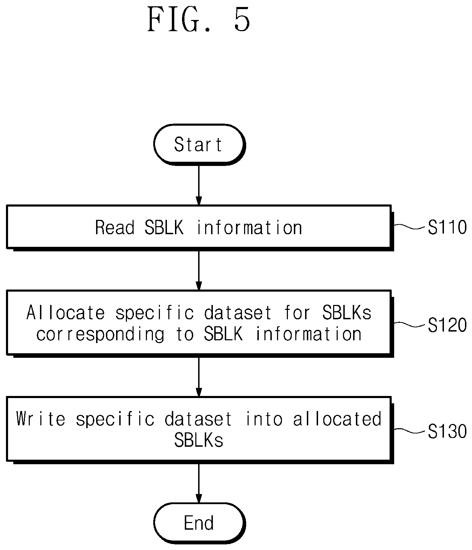

FIG. 5 illustrates an operating method of the storage device 110 according to some example embodiments. Referring to FIGS. 1 and 4, and FIG. 5, in operation S110, the storage controller 112 may read sub-block (SBLK) information from the nonvolatile memory device 111. For example, the sub-block (SBLK) information may be information which is obtained through a test operation in the process of manufacturing the storage device 110 and is written in the nonvolatile memory device 111. The sub-block (SBLK) information may include program information or erase information of the first sub-block SBLK1, the second sub-block SBLK2, and the third sub-block SBLK3 of each of the a-th cell string CSa and the b-th cell string CSb, and/or information about reliability.

In operation S120, the storage controller 112 may allocate a specific, or alternatively, desired dataset for sub-blocks SBLKs corresponding to the sub-block (SBLK) information, for example, sub-blocks SBLKs allocated to a first region. For example, the storage controller 112 may receive a specific, or alternatively, desired identifier, for example, information for requesting to write data having a logical unit LU or a stream identifier in a specific, or alternatively, desired first region from the host 120. The storage controller 112 may allocate the dataset having the specific, or alternatively, desired identifier so as to be written in the specific, or alternatively, desired first region.

In operation S130, the storage controller 112 may write the specific, or alternatively, desired dataset having the specific, or alternatively, desired identifier in the sub-blocks SBLKs allocated to the first region.

In some example embodiments, the specific, or alternatively, desired identifier may be the logical unit LU indicating an RPMB (Replay Protected Memory Block). The RPMB may store security data such as a data encryption key. In some example embodiments, when it is advantageous for the host 120 to erase the security data stored in the RPMB, the host 120 may transmit and/or send the purge request to the storage controller 112 to prevent and/or reduce the likelihood of the leakage of the security data. For example, the purge request for the RPMB being the first region may be more frequent compared to any other region. Because the purge request may accompany the physical erase, processing the purge request may require or take a long or longer time than to invalidate the data.

The sub-block (SBLK) information may include information of sub-blocks, which are relatively fast in a program speed or erase speed and have the reliability secured in the test process of the storage device 110, from among the sub-blocks of each of the a-th cell string CSa and the b-th cell string CSb. In some example embodiments, in the test process of the storage device 110, the program or erase speed and the reliability may be tested. Information of the tested sub-blocks may be written in the nonvolatile memory device 111 as the sub-block (SBLK) information.

The storage controller 112 may select sub-blocks to be allocated to the RPMB in consideration of the program or erase speeds and the reliability. When sub-blocks, whose program or erase speed are fast while having the reliability, are allocated to the RPMB, a speed at which the purge request for the RPMB is performed may be improved.

In some example embodiments, there may exist a dataset which the host 120 does not write in the RPMB but has the security which the host 120 intends to secure through the purge request. The host 120 may assign a stream identifier to the corresponding dataset and may provide the stream identifier to the storage controller 112. The storage controller 112 may select a second region of the remaining region other than the region allocated to the RPMB in consideration of the program or erase speed and the reliability and may write data having the stream identifier designated by the host 120 in the second region.

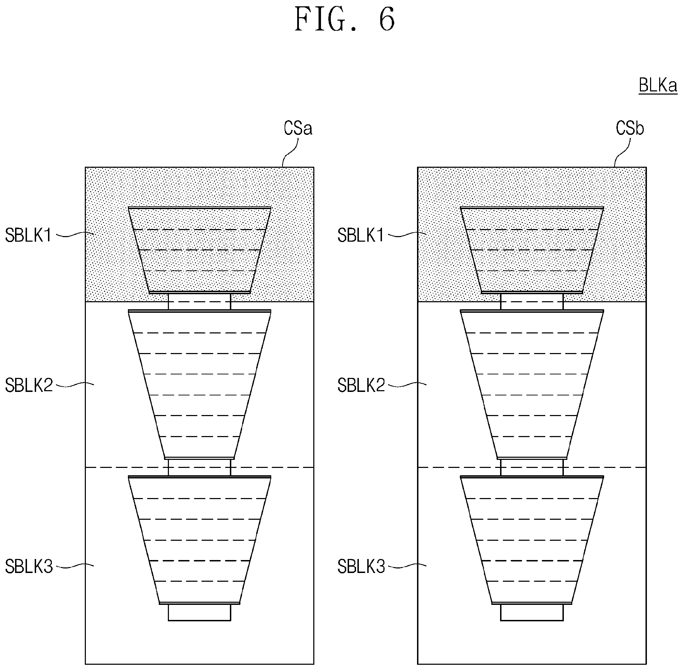

FIG. 6 illustrating an example of the a-th memory block BLKa in which a first region is allocated according to some example embodiments. Referring to FIG. 6, in the a-th memory block BLKa, the first sub-blocks SBLK1 at the uppermost end of the a-th cell string CSa and the b-th cell string CSb may be allocated to a first region.

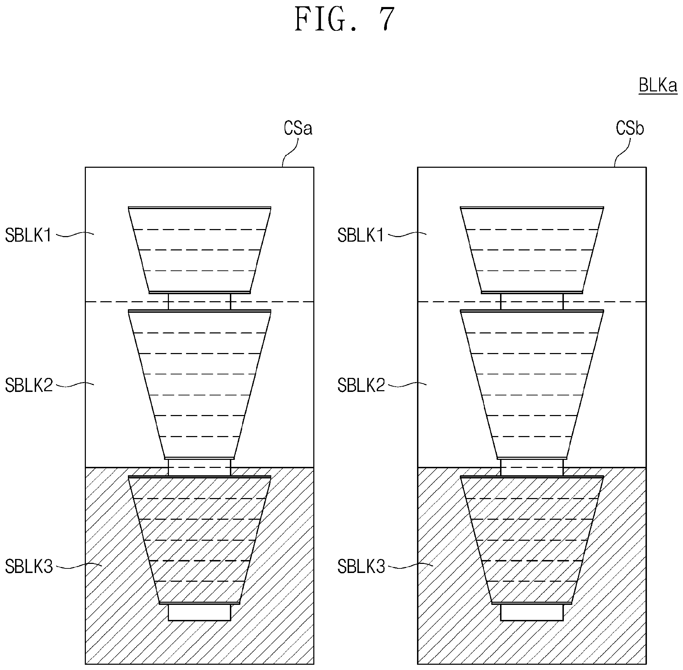

FIG. 7 illustrating another example of the a-th memory block BLKa in which a first region is allocated according to some example embodiments. Referring to FIG. 7, in the a-th memory block BLKa, the third sub-blocks SBLK3 at the lowermost end of the a-th cell string CSa and the b-th cell string CSb may be allocated to a first region.

In some example embodiments, the program or erase speed and the reliability may differ for each sub-block depending on the process of the nonvolatile memory device 111. The first region illustrated in FIGS. 6 and 7 according to some example embodiments is provided only as an example, and the first region may be allocated depending on the actual program or erase speed and the actual reliability of sub-blocks of the nonvolatile memory device 111.

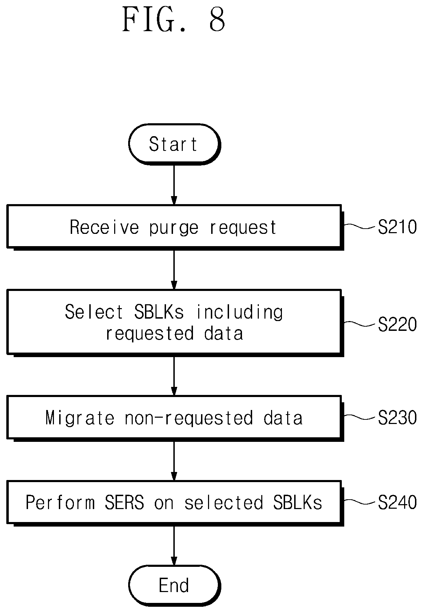

FIG. 8 illustrates an example in which the storage device 110 performs the purge operation depending on a request of the host 120 according to some example embodiments. Referring to FIGS. 1 and 8, in operation S210, the storage controller 112 may receive the purge request from the host 120. The purge request may include information for identifying data targeted for the purge operation, for example, an address or an identifier.

In operation S220, the storage controller 112 may select sub-blocks SBLKs including the requested data.

In operation S230, the storage controller 112 may migrate non-requested data. For example, the storage controller 112 may migrate data not targeted for the purge operation from among the data of the selected sub-blocks SBLKs into a free space of another first region.

In operation S240, the storage controller 112 may perform security erase SERS on the selected sub-blocks SBLKs. For example, the storage controller 112 may physically erase the data written in the selected sub-blocks SBLKs.

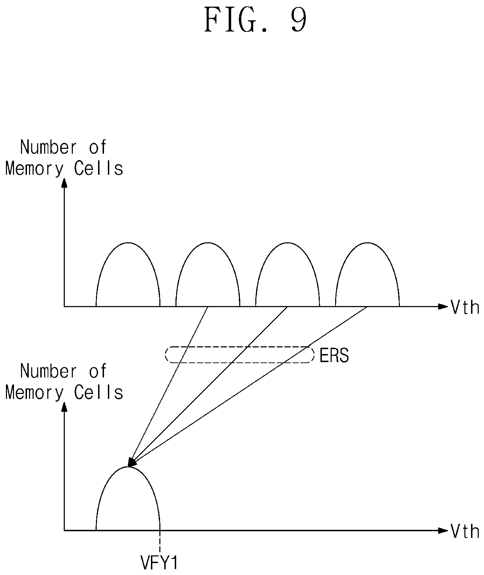

FIG. 9 illustrates an example in which an erase (ERS) operation is performed in the nonvolatile memory device 111 according to some example embodiments. In FIG. 9, the horizontal axis represents a threshold voltage Vth of a memory cell, and the vertical axis represents the number of memory cells.

Referring to FIGS. 1, 3, 4, and 9, when data are written through the write operation, memory cells of a specific sub-block(s) among the first sub-block SBLK1, the second sub-block SBLK2, and the third sub-block SBLK3 of the a-th cell string CSa or the b-th cell string CSb may be programmed to be included in different threshold voltage ranges. Different threshold voltage ranges may correspond to different states. For example, a state corresponding to the lowest threshold voltage range may be an erase state. Threshold voltage ranges higher than the erase state may respectively correspond to different program states.

When the erase (ERS) operation is performed, the memory cells of the specific sub-block(s) may be erased to the erase state having the threshold voltage range lower than a first verify voltage VFY1.

In some example embodiments, the erase (ERS) operation may be performed to secure a free block and to write new data in the free block. In some example embodiments, because data will be written through the write operation after the erase (ERS) operation, errors which are capable of occurring when the memory cells are left alone in the erase state may not occur. For example, the deep erase that threshold voltages of the memory cells of the erase state become excessively low may not occur, and there may be no influence on the reliability of data written in the memory cells.

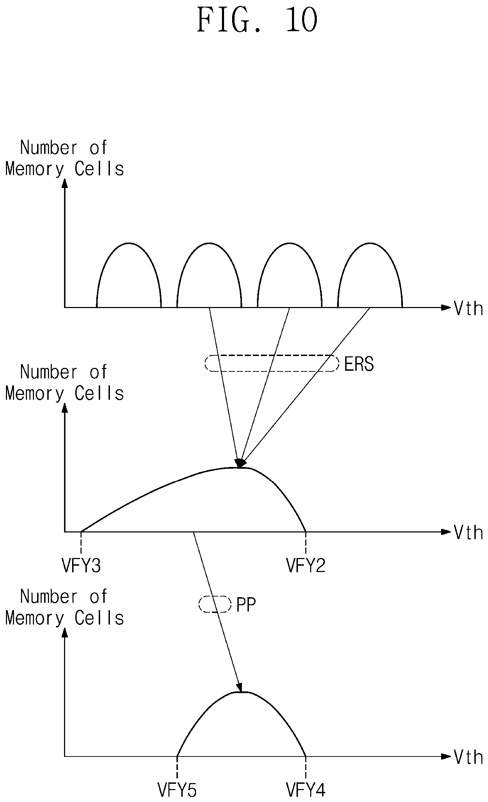

FIG. 10 illustrates an example in which the security erase (SERS) operation is performed in the nonvolatile memory device 111 according to some example embodiments. In FIG. 10, the horizontal axis represents a threshold voltage Vth of a memory cell, and the vertical axis represents the number of memory cells.

Referring to FIGS. 1, 2, 3, 4, and 10, when data are written through the write operation, memory cells of the first memory block BLK1 may be programmed to be included in different threshold voltage ranges. Different threshold voltage ranges may correspond to different states. For example, a state corresponding to the lowest threshold voltage range may be an erase state. Threshold voltage ranges higher than the erase state may respectively correspond to different program states.

The security erase (SERS) operation may include the erase (ERS) operation and a pre-program (PP) operation. In some example embodiments, the erase (ERS) operation of the security erase (SERS) operation may be called shallow erase in that the erase is made to be relatively small. For example, when the erase (ERS) operation is performed, the memory cells of the first memory block BLK1 may be erased to a state whose threshold voltage range is lower than a second verify voltage VFY2 and is higher than a third verify voltage VFY3. In some example embodiments, the level of the second verify voltage VFY2 used in the erase (ERS) operation of the security erase (SERS) operation may be higher than the level of the first verify voltage VFY1 used in the erase (ERS) operation.

In some example embodiments, when the pre-program (PP) operation is performed, the memory cells of the first memory block BLK1 may be programmed to a state whose threshold voltage range is lower than a fourth verify voltage VFY4 and is higher than a fifth verify voltage VFY5. In some example embodiments, the level of the fifth verify voltage VFY5 used in the pre-program (PP) operation of the security erase (SERS) operation may be higher than the level of the second verify voltage VFY2 used in the erase (ERS) operation of the security erase (SERS) operation.

In some example embodiments, a threshold voltage distribution range of memory cells in which the security erase (ERS) operation is performed may be wider than a threshold voltage distribution range of an erase state or one program state when data are written.

In some example embodiments, the security erase (SERS) operation may be arbitrarily initiated for the host 120 to erase the security data, rather than securing a free block and writing new data. Accordingly, memory cells may be left alone, and error capable of occurring when the memory cells are left alone may occur. For example, the deep erase that threshold voltages of memory cells become low or lower may occur. The security erase (SERS) operation may be performed to adjust a threshold voltage range of memory cells to be higher than a threshold voltage range of the erase state. In some example embodiments, even though threshold voltages of the memory cells become lower, the threshold voltages of the memory cells may not become lower than the threshold voltage range of the erase state.

When the storage controller 112 intends to write data in memory cells of another specific sub-block(s) in which the security erase (SERS) operation is completed, the storage controller 112 may perform the erase (ERS) operation on the memory cells of the another specific sub-block(s) such that the first memory block BLK1 is changed to a free block and may then write the data in the another specific sub-block(s). Accordingly, the disturbance which is caused when memory cells are left alone in the erase state may not affect the reliability of data to be written later.

In some example embodiments, the erase (ERS) operation described with reference to FIG. 9 may be a background operation which is performed when the storage device 110 is in an idle state. Accordingly, the erase (ERS) operation described with reference to FIG. 9 may not affect the latency of the storage device 110.

In some example embodiments, the security erase (SERS) operation described with reference to FIG. 10 may request to immediately physically erase memory cells. Accordingly, the security erase (SERS) operation described with reference to FIG. 10 may affect the latency of the storage device 110.

The storage device 110 according to some example embodiments may select sub-blocks to be allocated to the first region in consideration of the program or erase speed and the reliability. Accordingly, the erase (SERS) operation according to the purge request may suppress the latency of the storage device 110 from increasing.

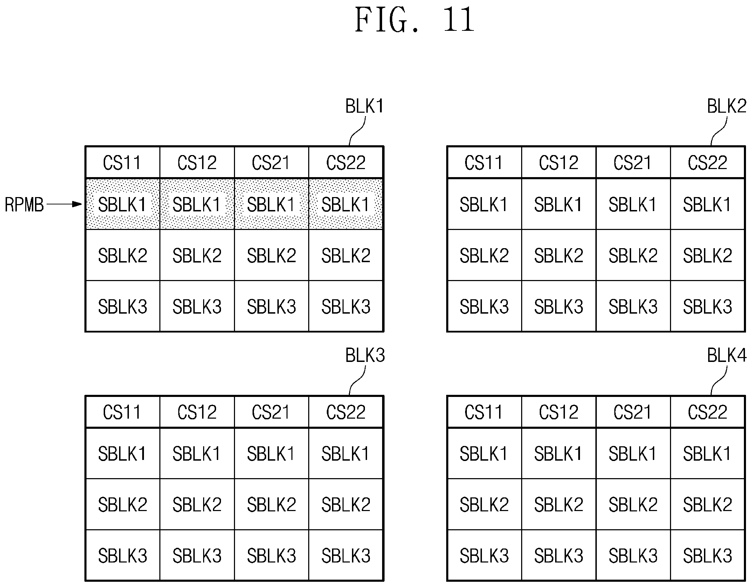

FIG. 11 illustrates an example in which a first region is allocated in a plurality of memory blocks according to some example embodiments. In some example embodiments, it is assumed that a first region is the RPMB. However, some example embodiments are not limited to the RPMB. In some example embodiments, in addition to the RPMB, a region in which specific-purpose data are separately managed may be allocated to the first region. In some example embodiments, a region which is configured such that the write/read/erase operation is performed within a given time to be relatively faster than any other region(s), not a typical write/read/erase region may be allocated to the first region. Also, in some example embodiments, a region which supports an erase function of processing the physical erase request immediately at a point in time when the host 120 or the storage controller 112 generates the erase request may be allocated to the first region.

Referring to FIGS. 1, 2, 3, and 11, the storage controller 112 may allocate, to the RPMB, the first sub-blocks SBLK1 of the first memory block BLK1 among the first memory block BLK1, the second memory block BLK2, the third memory block BLK3, and the fourth memory block BLK4 of the memory cell array 210, for example, the first sub-blocks SBLK1 of the eleventh cell string CS11, the twelfth cell string CS12, the twenty-first cell string CS21, and the twenty-second cell string CS22.

In some example embodiments, when storage capacities of sub-blocks of each memory block are different from each other, sub-blocks with a relatively small size or sub-blocks having a storage capacity coinciding with the design purpose of the RPMB may be allocated to the RPMB. In some example embodiments, a sub-block having the highest program or erase speed from among the sub-blocks of each memory block may be allocated to the RPMB. A sub-block having a small channel size from among the memory blocks of each memory block, for example, a sub-block at the lower end may be allocated to the RPMB. Based on a physical structure in which an operating voltage is supplied, a sub-block capable of attempting the program and erase operations relatively faster from among the sub-blocks of each memory block may be allocated to the RPMB. In some example embodiments, a sub-block capable of satisfying a required or advantageous time of the purge operation of the RPMB from among the sub-blocks of each memory block may be allocated to the RPMB.

In some example embodiments, as the program and erase operations are repeated, the reliability of memory cells may decrease. Accordingly, the lifetime of memory cells may be measured as the number of program and erase cycles. Because the security erase (SERS) operation according to the purge request causes data migration, erase, and program operations, the lifetime of memory cells of the RPMB may be exhausted faster than the lifetime of any other memory cells.

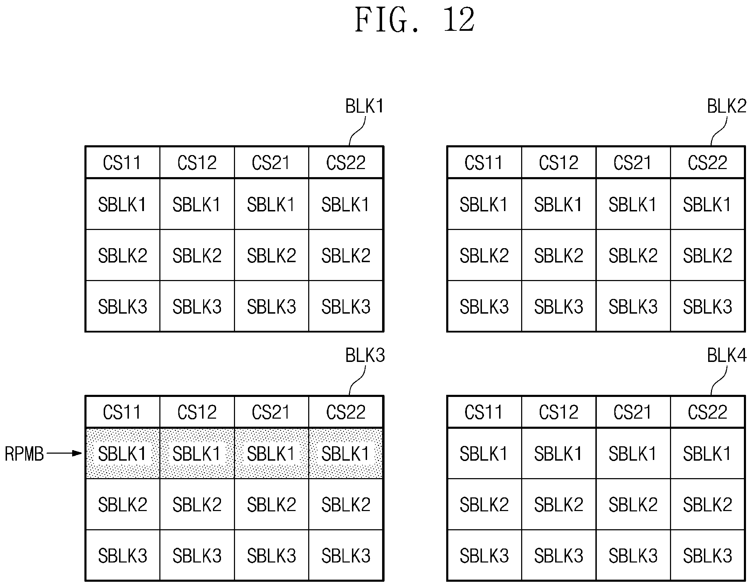

For the wear leveling, for example, the leveling of program and erase cycles, when the wear level of the RPMB becomes high or higher than the wear level of any other memory cells, for example, when a wear level difference is greater than a first threshold value determined in advance, the storage controller 112 may allocate sub-blocks of the same location of the other memory block to the first region. FIG. 12 illustrates an example in which the RPMB is allocated to the first sub-blocks SBLK1 of the third memory block BLK3 according to some example embodiments.

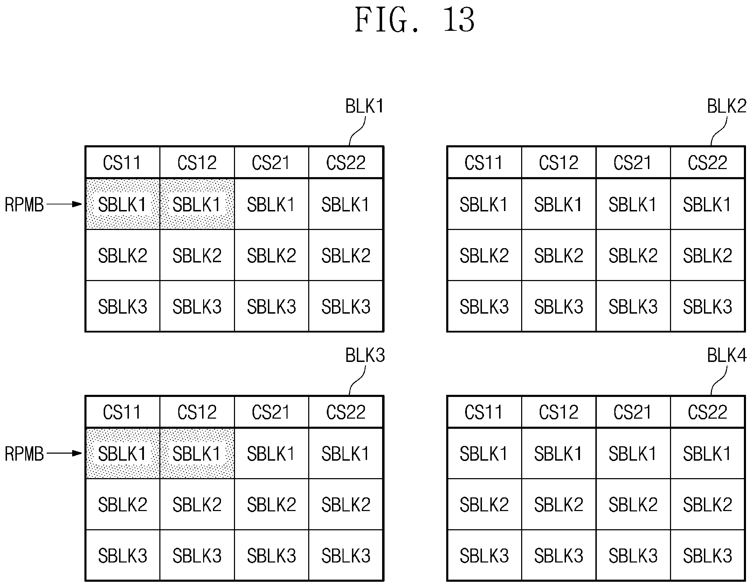

In some example embodiments, in the process of allocating, to the RPMB, the first sub-blocks SBLK1 of the second memory block BLK2 instead of the first sub-blocks SBLK1 of the first memory block BLK1, there may occur the event that some of the first sub-blocks SBLK1 of the first memory block BLK1 and some of the first sub-blocks SBLK1 of the second memory block BLK2 are together allocated to the RPMB. FIG. 13 illustrates an example in which some of the first sub-blocks SBLK1 of the first memory block BLK1 and some of the first sub-blocks SBLK1 of the second memory block BLK2 are together allocated to the RPMB according to some example embodiments.

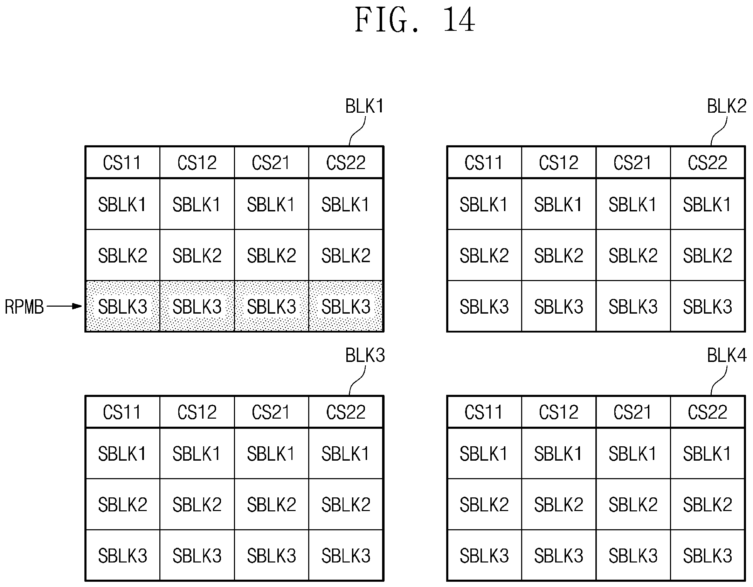

In some example embodiments, compared to the wear level of any other sub-blocks, when the wear level of the first sub-blocks SBLK1 of the first memory block BLK1, the second memory block BLK2, the third memory block BLK3, and the fourth memory block BLK4 is greater than a wear level of other sub-blocks, for example, as much as a second threshold value, the storage controller 112 may allocate any other sub-blocks, for example, the third sub-blocks SBLK3 of the first memory block BLK1 to the RPMB. FIG. 14 illustrates an example in which the storage controller 112 allocates the third sub-blocks SBLK3 of the first memory block BLK1 to the RPMB according to some example embodiments.

As described above, based on the wear level, the storage controller 112 may change sub-blocks to be allocated to the RPMB in a memory block and may change sub-blocks to be allocated to the RPMB between memory blocks.

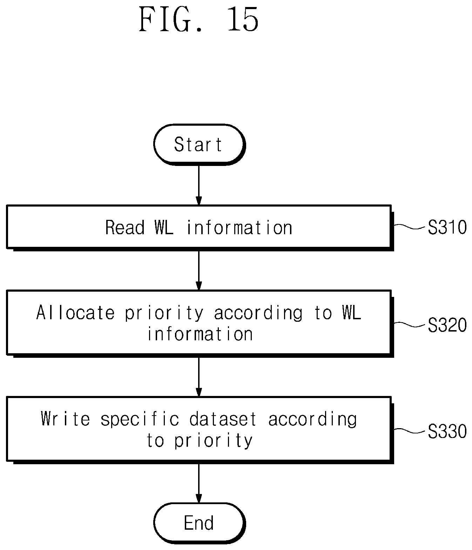

FIG. 15 illustrates an operating method of the storage device 110 according to some example embodiments. Referring to FIGS. 1, 4, and 15, in operation S310, the storage controller 112 may read word line (WL) information from the nonvolatile memory device 111. For example, the word line (WL) information may be information which is obtained through a test operation in the process of manufacturing the storage device 110 and is written in the nonvolatile memory device 111. The word line (WL) information may include information of a program or erase speed of each of the first sub-block SBLK1, the second sub-block SBLK2, and the third sub-block SBLK3 included in each of the a-th cell string CSa and the b-th cell string CSb or information about the amount of energy consumed in the program or erase operation thereof.

In operation S320, the storage controller 112 may allocate priorities to sub-blocks SBLK allocated to the first region, depending on the word line (WL) information.

In operation S330, the storage controller 112 may write a specific dataset in the first region based on the priorities.

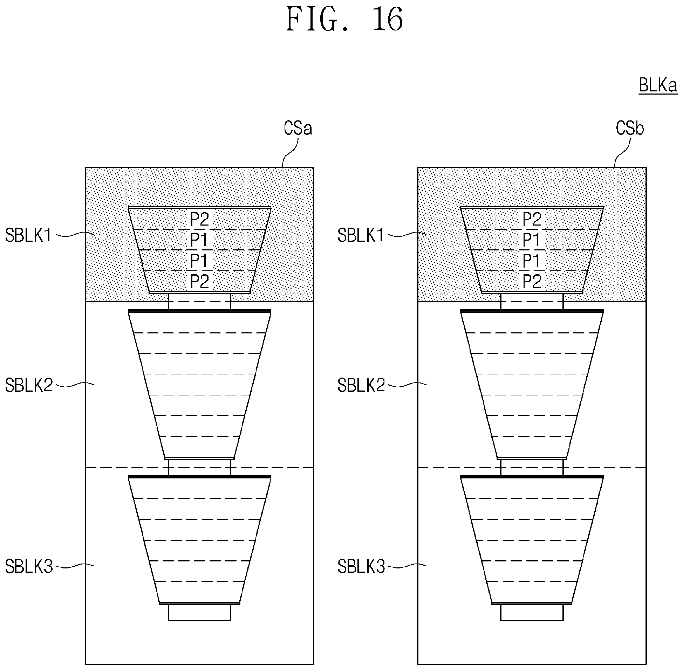

FIG. 16 illustrates an example in which priorities are assigned by the storage controller 112 according to some example embodiments. For example, it is assumed that the storage controller 112 allocates the first sub-blocks SBLK1 of the a-th memory block BLKa to the first region.

The storage controller 112 may assign a first priority P1 and a second priority P2 to the first sub-blocks SBLK1. The first priority P1 and the second priority P2 may be determined based on information of the program or erase speed and/or information of an energy that is advantageous to provide for the program or erase operation, which is included in the word line (WL) information.

In some example embodiments, when a difference between the program or erase speeds of memory cells is greater than or equal to a third threshold value, priorities may be determined based on the program or erase speeds.

When a difference between energies that are advantageous to provide for the program or erase operations of memory cells is greater than or equal to a fourth threshold value, priorities may be determined based on the energies that are advantageous to provide for the program or erase operations.

In some example embodiments, the storage controller 112 may assign priorities in comprehensive consideration of the wear level, the program or erase speed, and the energy that is advantageous to provide for the program or erase operation.

Assuming that priorities are assigned based on the word line (WL) information, when the purge request is generated before the first region is fully filled with data, data may be in a state of having been written in memory cells having a high priority. Accordingly, it is possible to process the purge request at a high or higher program or erase speed and/or with a small or smaller program or erase energy.

In some example embodiments, the nonvolatile memory device 111 may be implemented with three or more layers. A peripheral circuit and the memory cell array 210 may be distributed and implemented into the three or more layers. The peripheral circuit may include the row decoder block 220, the page buffer block 230, the pass/fail check block (PFC) 240, the data input and output block 250, the data buffer 260, the command and address buffer 270, and the control logic block 280.

The three or more layers may be implemented with a first memory cell array on the peripheral circuit and a second memory cell array on the first memory cell array. In some example embodiments, the storage controller 112 may allocate specific sub-blocks of a specific memory block of the first memory cell array or the second memory cell array to the first region such as an RPMB.

The three or more layers may be implemented with a first memory cell array, a second memory cell array on the peripheral circuit, and a second memory cell array on the peripheral circuit. In some example embodiments, the storage controller 112 may allocate specific sub-blocks of a specific memory block of the first memory cell array or the second memory cell array to the first region such as an RPMB.

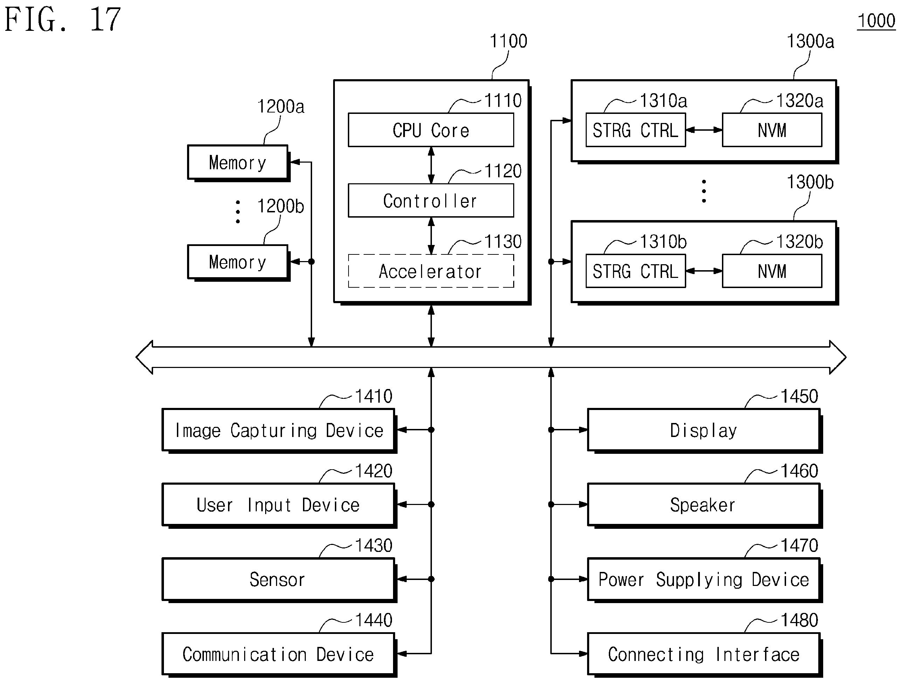

FIG. 17 is a diagram of a system 1000 to which a storage device is applied, according to some example embodiments. The system 1000 of FIG. 17 may basically be a mobile system, such as a portable communication terminal (e.g., a mobile phone), a smartphone, a tablet personal computer (PC), a wearable device, a healthcare device, and/or an Internet of things (IOT) device. However, example embodiments of the system 1000 of FIG. 17 are not necessarily limited to the mobile system and, in some example embodiments, the system 1000 of FIG. 17 may be a PC, a laptop computer, a server, a media player, and/or an automotive device (e.g., a navigation device).

Referring to FIG. 17, the system 1000 may include a main processor 1100, memories (e.g., 1200a and 1200b), and storage devices (e.g., 1300a and 1300b). In some example embodiments, the system 1000 may include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented as a general-purpose processor, a dedicated processor, and/or an application processor.

The main processor 1100 may include at least one CPU core 1110 and further include a controller 1120 configured to control the memories 1200a and 1200b and/or the storage devices 1300a and 1300b. In some example embodiments, the main processor 1100 may further include an accelerator 1130, which is a dedicated circuit for a high-speed data operation, such as an artificial intelligence (AI) data operation. The accelerator 1130 may include a graphics processing unit (GPU), a neural processing unit (NPU) and/or a data processing unit (DPU) and be implemented as a chip that is physically separate from the other components of the main processor 1100.

The memories 1200a and 1200b may be used as main memory devices of the system 1000. Although each of the memories 1200a and 1200b may include a volatile memory, such as static random access memory (SRAM) and/or dynamic RAM (DRAM), each of the memories 1200a and 1200b may include nonvolatile memory, such as a flash memory, phase-change RAM (PRAM) and/or resistive RAM (RRAM). The memories 1200a and 1200b may be implemented in the same package as the main processor 1100.

The storage devices 1300a and 1300b may serve as nonvolatile storage devices configured to store data regardless of whether power is supplied thereto, and have larger storage capacity than the memories 1200a and 1200b. The storage devices 1300a and 1300b may respectively include storage controllers (STRG CTRL) 1310a and 1310b and NVMs (Non-Volatile Memories) 1320a and 1320b configured to store data via the control of the storage controllers 1310a and 1310b. Although the NVMs 1320a and 1320b may include flash memories having a two-dimensional (2D) structure and/or a three-dimensional (3D) V-NAND structure, the NVMs 1320a and 1320b may include other types of NVMs, such as PRAM and/or RRAM.

The storage devices 1300a and 1300b may be physically separated from the main processor 1100 and included in the system 1000 and/or implemented in the same package as the main processor 1100. In some example embodiments, the storage devices 1300a and 1300b may have types of solid-state devices (SSDs) and/or memory cards and be removably combined with other components of the system 1000 through an interface, such as the connecting interface 1480 that will be described below. The storage devices 1300a and 1300b may be devices to which a standard protocol, such as a universal flash storage (UFS), an embedded multi-media card (eMMC), and/or a non-volatile memory express (NVMe), is applied, but example embodiments are not limited thereto.

The image capturing device 1410 may capture still images and/or moving images. The image capturing device 1410 may include a camera, a camcorder, and/or a webcam.

The user input device 1420 may receive various types of data input by a user of the system 1000 and include a touch pad, a keypad, a keyboard, a mouse, and/or a microphone.

The sensor 1430 may detect various types of physical quantities, which may be obtained from the outside of the system 1000, and convert the detected physical quantities into electric signals. The sensor 1430 may include a temperature sensor, a pressure sensor, an illuminance sensor, a position sensor, an acceleration sensor, a biosensor, and/or a gyroscope sensor.

The communication device 1440 may transmit and/or send and receive signals between other devices outside the system 1000 according to various communication protocols. The communication device 1440 may include an antenna, a transceiver, and/or a modem.

The display 1450 and the speaker 1460 may serve as output devices configured to respectively output visual information and auditory information to the user of the system 1000.

The power supplying device 1470 may appropriately convert power supplied from a battery (not shown) embedded in the system 1000 and/or an external power source, and supply the converted power to each of components of the system 1000.

The connecting interface 1480 may provide connection between the system 1000 and an external device, which is connected to the system 1000 and capable of transmitting and/or sending and receiving data to and from the system 1000. The connecting interface 1480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and/or a compact flash (CF) card interface.

In some example embodiments, the host 120 described with reference to FIGS. 1 to 16 may be implemented with the main processor 1100. In some example embodiments, the storage device 110 described with reference to FIGS. 1 to 16 may be implemented with one of the storage devices 1300a and 1300b. At least one of the storage devices 1300a and 1300b may be implemented in the SCA structure and may allocate the RPMB based on information of sub-blocks. Also, in some example embodiments at least one of the storage devices 1300a and 1300b may set priorities of writing data, based on word line information.

In the above example embodiments, components according to some example embodiments are described by using the terms "first", "second", "third", etc. However, the terms "first", "second", "third", etc. may be used to distinguish components from each other and do not limit the present inventive concepts. For example, the terms "first", "second", "third", etc. do not involve an order or a numerical meaning of any form.

In the above example embodiments, components according to some example embodiments are referenced by using blocks. The blocks may be implemented with various hardware devices, such as an integrated circuit (IC), an application specific IC (ASIC), a field programmable gate array (FPGA), and a complex programmable logic device (CPLD), firmware driven in hardware devices, software such as an application, or a combination of a hardware device and software. In some example embodiments, the blocks may include circuits implemented with semiconductor elements in an integrated circuit, or circuits enrolled as an intellectual property (IP). For example, it will be understood that, as described herein, any devices, electronic devices, modules, units, and/or portions thereof according to any of the example embodiments, and/or any portions thereof may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electrical Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, electronic devices, modules, units, and/or portions thereof according to any of the example embodiments.

According to some example embodiments, a storage device may allocate a specific region depending on features of sub-blocks and may assign priorities for writing data depending on features of word lines in the specific region. The speed of the purge operation may be improved by the features of the sub-blocks and the features of the word lines.

While the present inventive concepts have been described with reference to some example embodiments thereof, it will be apparent to those of ordinary skill in the art that various changes and modifications may be made thereto without departing from the spirit and scope of the present inventive concepts as set forth in the following claims.

## Claims

1. A storage device (110), comprising:
a nonvolatile memory device (111, 200) including a plurality of memory blocks (BLK), each memory block of the plurality of memory blocks including a plurality of sub-blocks (SBLK); and
a storage controller (112) configured to
send a command and address to the nonvolatile memory device (111, 200),
communicate first data with the nonvolatile memory device (111, 200),
allocate one of the plurality of sub-blocks (SBLK) to a first region based on first information about program speeds or erase speeds of the plurality of sub-blocks (SBLK), and
write second data of a write request received together with second information from an external host device (120) in the first region.

2. The storage device of claim 1, wherein the storage controller is configured to allocate first sub-blocks of the plurality of sub-blocks to the first region, the first sub-blocks being fast in the program speeds or the erase speeds.

3. The storage device of claim 1, wherein the second information includes a specific logical unit or a specific stream identifier.

4. The storage device of claim 1, wherein
the nonvolatile memory device includes,
a substrate; and
a plurality of cell strings arranged on the substrate along a first direction and a second direction,
each cell string of the plurality of cell strings includes a plurality of stacks stacked on the substrate along a third direction, and
each stack of the plurality of stacks includes a plurality of memory cells stacked along the third direction.

5. The storage device of claim 4, wherein
each stack of the plurality of stacks correspond to a different sub-block of the plurality of sub-blocks, and
a first sub-block of a first cell string of the plurality of cell strings with a second sub-block of a second cell string of the plurality of cell strings is a super sub-block.

6. The storage device of claim 5, wherein
the first sub-block corresponds to a first stack of a first plurality of stacks of the first cell string, the first stack at an uppermost end of the first cell string, and
the second sub-block corresponds to a second stack of a second plurality of stacks of the second cell string, the second stack at an uppermost end of the second cell string.

7. The storage device of claim 5, wherein
the first sub-block corresponds to a first stack of a first plurality of stacks of the first cell string, the first stack being at a lowermost end of the first cell string, and
the second sub-block corresponds to a second stack of a second plurality of stacks of the second cell string, the second stack at a lowermost end of the second cell string.

8. The storage device of claim 1, wherein the first region includes a replay protected memory block (RPMB).

9. The storage device of claim 1, wherein
the second information indicates that a probability of a purge operation being requested for the second data is high compared to any other data, and
the purge operation includes an operation of physically erasing the second data.

10. The storage device of claim 9, wherein the purge operation includes:
an erase operation of decreasing threshold voltages of memory cells storing the second data to a first threshold voltage or lower; and
a pre-program operation of increasing the threshold voltages of the memory cells to a second threshold voltage or higher.

11. The storage device of claim 1, wherein the storage controller is configured to allocate a first portion of at least one memory block among the plurality of memory blocks to the first region.

12. The storage device of claim 11, wherein the storage controller is configured to allocate a second portion of the at least one memory block to the first region in response to a wear level of the first portion of the at least one memory block increasing.

13. The storage device of claim 11, wherein the storage controller is configured to allocate a portion of a memory block different from the at least one memory block to the first region in response to a wear level of the first portion of the at least one memory block increasing.

14. The storage device of claim 1, wherein the storage controller is configured to:
read third information about memory cells allocated to the first region from the nonvolatile memory device; and
write the second data of the write request received together with the second information from the external host device in the first region based on the third information.

15. The storage device of claim 14, wherein the third information includes information about program speeds or erase speeds of the memory cells.

## Amended claims

### Amended claims in accordance with Rule 137(2) EPC.

1. A storage device (110), comprising:
a nonvolatile memory device (111, 200) including a plurality of memory blocks (BLK), each memory block of the plurality of memory blocks including a plurality of sub-blocks (SBLK); and
a storage controller (112) configured to
send a command and address to the nonvolatile memory device (111, 200),
communicate first data with the nonvolatile memory device (111, 200),
allocate one of the plurality of sub-blocks (SBLK) to a first region being a Replay Protected Memory Block (RPMB) based on first information about erase speeds of the plurality of sub-blocks (SBLK),
write second data of a write request received together with second information including a logical unit indicating the RPMB from an external host device (120) in the first region, and
perform a purge operation on the first region in response to a purge request from the external host device (120),
wherein the second data is security data and the purge operation includes an operation of physically erasing the second data.

2. The storage device of claim 1, wherein the storage controller is configured to allocate first sub-blocks of the plurality of sub-blocks to the first region, the first sub-blocks being fast in the erase speeds.

3. The storage device of claim 1, wherein
the nonvolatile memory device includes,
a substrate; and
a plurality of cell strings arranged on the substrate along a first direction and a second direction,
each cell string of the plurality of cell strings includes a plurality of stacks stacked on the substrate along a third direction, and
each stack of the plurality of stacks includes a plurality of memory cells stacked along the third direction.

4. The storage device of claim 3, wherein
each stack of the plurality of stacks correspond to a different sub-block of the plurality of sub-blocks, and
a first sub-block of a first cell string of the plurality of cell strings with a second sub-block of a second cell string of the plurality of cell strings is a super sub-block.

5. The storage device of claim 4, wherein
the first sub-block corresponds to a first stack of a first plurality of stacks of the first cell string, the first stack at an uppermost end of the first cell string, and
the second sub-block corresponds to a second stack of a second plurality of stacks of the second cell string, the second stack at an uppermost end of the second cell string.

6. The storage device of claim 4, wherein
the first sub-block corresponds to a first stack of a first plurality of stacks of the first cell string, the first stack being at a lowermost end of the first cell string, and
the second sub-block corresponds to a second stack of a second plurality of stacks of the second cell string, the second stack at a lowermost end of the second cell string.

7. The storage device of claim 1, wherein
the second information indicates that a probability of the purge operation being requested for the second data is high compared to any other data.

8. The storage device of claim 7, wherein the purge operation includes:
an erase operation of decreasing threshold voltages of memory cells storing the second data to a first threshold voltage or lower; and
a pre-program operation of increasing the threshold voltages of the memory cells to a second threshold voltage or higher.

9. The storage device of claim 1, wherein the storage controller is configured to allocate a first portion of at least one memory block among the plurality of memory blocks to the first region.

10. The storage device of claim 9, wherein the storage controller is configured to allocate a second portion of the at least one memory block to the first region in response to a wear level of the first portion of the at least one memory block increasing.

11. The storage device of claim 9, wherein the storage controller is configured to allocate a portion of a memory block different from the at least one memory block to the first region in response to a wear level of the first portion of the at least one memory block increasing.

12. The storage device of claim 1, wherein the storage controller is configured to:
read third information about memory cells allocated to the first region from the nonvolatile memory device; and
write the second data of the write request received together with the second information from the external host device in the first region based on the third information.

13. The storage device of claim 12, wherein the third information includes information about erase speeds of the memory cells.
